# EUROPÄISCHE PATENTSCHRIFT

(11) **EP 1 552 732 B1**
(45) Veröffentlichungstag und Bekanntmachung des Hinweises auf die Patenterteilung: **22.04.2009**
(21) Anmeldenummer: 03757982.8
(22) Anmeldetag: 15.10.2003
(51) Int. Cl.: H05K 3/46

(54) **VERFAHREN UND VORRICHTUNG ZUM FÜGEN VON ZUMINDEST ZWEI BAUTEILEN**
METHOD AND DEVICE FOR JOINING AT LEAST TWO PARTS
PROCEDE ET DISPOSITIF PERMETTANT DE JOINDRE AU MOINS DEUX COMPOSANTS

(30) Priorität: 15.10.2002 DE 10248020
(43) Veröffentlichungstag der Anmeldung: 13.07.2005
(73) Patentinhaber: Fraunhofer-Gesellschaft zur Förderung der angewandten Forschung e.V., 80686 München (DE); Mühlbauer AG, 93426 Roding (DE)
(72) Erfinder: SCHUBERT, Andreas, 01219 Dresden (DE); HOCHMANN, Sven, 01219 Dresden (DE); GOD, Ralf, 01099 Dresden (DE); SCHNEIDER, Jörg, 09130 Chemnitz (DE)
(74) Vertreter: Klitzsch, Gottfried
(86) Internationale Anmeldenummer: PCT/EP2003/011430
(87) Internationale Veröffentlichungsnummer: WO 2004/036969

(56) Entgegenhaltungen:
- WO-A-98/04106
- WO-A-99/38368
- DE-A- 19 714 755
- US-A- 3 728 183
- US-A- 5 817 207
- US-A- 5 986 569
- US-A1- 2002 007 906

## Beschreibung

Die vorliegende Erfindung betrifft ein Verfahren und eine Vorrichtung zum Fügen von zumindest zwei Bauteilen. Insbesondere betrifft die vorliegende Erfindung ein Verfahren zum Fügen von zumindest zwei dünnen Folien.

Auf verschiedenen technischen Gebieten ist es notwendig, zwei Folien miteinander zu verbinden. Beispielsweise werden auf dem Gebiet der Radiofrequenzidentifikation sogenannte RFI D-Datenträger in Form von RFID-Etiketten verwendet, die aus flexiblem Antennensubstrat mit Metallbeschichtung und vormontierten RFID-Chips auf Metallfolienbrücken bestehen. Die verschiedenen Folien, welche die Elemente tragen, werden miteinander verbunden. In üblicher Weise werden hierzu Verbindungstechniken wie Kleben, Elektronenstrahlschweißen, Ultraschallschweißen, Bonden oder Löten eingesetzt.

Bei Blechen mit größerer Dicke kommen auch umformtechnische Fügeverfahren zum Einsatz, wobei in meist mehrstufigen Verfahren eine mechanische Verbindung zwischen den beiden Blechen durch plastische Umformung derselben erzielt wird. Diese Verfahren sind als Durchsetzfügen bzw. Clinchen bekannt.

Den meisten Verfahren auf dem Gebiet des Durchsetzfügens ist gemeinsam, dass zwei Bleche in Anlage miteinander durch einen Fügestempel plastisch verformt werden. Bei dieser plastischen Verformung wird das Material der beiden Bleche derart verformt, dass sich für beide Bleche eine Art Ausstülpung bildet. Durch entsprechend geformte Gegenhalter oder Matrizen sowie die Form des Fügestempels bzw. der Bewegung des Fügestempels (wie beispielsweise einer Taumelbewegung) wird ein Hinterschneidungsbereich gebildet, in dem beiden Blechen im Fügebereich eine spezielle, 3-dimensionale Form gegeben wird. Durch die massive plastische Umformung der beiden Bleche im Fügebereich wird eine pilzförmige Ausstülpung geschaffen, die durch die Hinterschneidung eine formschlüssige Verbindung zwischen den Blechen bildet. In einem weiteren Gebiet des Durchsetzfügens wird in einer zweiten Stufe die genannte Ausstülpung zurückgestaucht und so eine form- und kraftschlüssige Faltung gebildet, welche die beiden Bleche miteinander verbindet.

Verfahren zum Fügen von Bauteilen sind aus den Dokumenten WO98/04106, WO99/38368 und US3,728,183 bekannt.

Es ist die Aufgabe der vorliegenden Erfindung, ein Verfahren und eine Vorrichtung zum Fügen von zumindest zwei Bauteilen zu schaffen, wobei die Fügung auf einfache und zuverlässige Weise durchgeführt werden kann.

Gemäß dem Verfahrensaspekt wird diese Aufgabe erfindungsgemäß gelöst durch ein Verfahren zum Fügen von zumindest zwei Bauteilen, die zumindest in einem Fügebereich in Anlage miteinander gebracht sind, wobei ein Trägerelement mit einem ersten der zwei Bauteile zumindest in dem Fügebereich in Anlage ist, zumindest ein Vorsprung die Bauteile im Fügebereich in Richtung zu dem Trägerelement durchsetzt, das Trägerelement zumindest in dem Fügebereiche gegen die Durchsetzbewegung des Vorsprunges flächig abgestützt wird, und das Durchsetzen des Vorsprunges durch die Bauteile und die entgegengesetzte flächige Abstützung des Trägerelementes eine plastische Verformung des durchgesetzten Materials der Bauteile in Richtung quer zu der Durchsetzbewegung des Vorsprunges unter Verformung des Trägerelementes bewirkt.

Gemäß einem bevorzugten Ausführungsbeispiel besteht das Trägerelement aus einem elastischen und/oder plastisch-verformbaren Werkstoff.

Es ist bevorzugt, dass der Vorsprung zunächst in ein zweites Bauteile eindringt und Material des zweiten Bauteils in Richtung auf das erste Bauteile verdrängt, und durch eine Weiterführung der Durchsetzbewegung des Vorsprunges Material des ersten Bauteils in Richtung auf das Trägerelement verdrängt wird, und das verdrängte Material des ersten und des zweiten Bauteils im wesentlichen in das Trägerelement eindringt, wobei die plastische Verformung des durchgesetzten Materials der Bauteile quer zur Durchsetzbewegung einen Hinterschneidungsbereich mit dem ersten und dem zweiten Bauteil bildet.

In besonders bevorzugter Weise führt der Vorsprung bei der Durchsetzbewegung durch die Bauteile einen partiellen Schneidvorgang an beiden Bauteilen entlang zumindest einer Linie durch.

Gemäß einem bevorzugten Ausführungsbeispiel erfolgt der Schneidvorgang entlang zumindest einer Geraden. Der Schneidvorgang kann ebenso entlang zweier paralleler Geraden erfolgen. Jedoch ist die Form der Schneidlinie frei wählbar, zumindest solange und soweit der Hinterschnitt nicht behindert wird.

In besonders bevorzugter Weise erfolgt die Durchsetzbewegung des Vorsprunges in einer einzigen kontinuierlichen Hubbewegung.

Es ist bevorzugt, dass die flächige Abstützung des Trägerelementes in einer Ebene erfolgt. In bevorzugter Weise erfolgt die Abstützung des Trägerelementes großflächig.

Gemäß einem bevorzugten Ausführungsbeispiel sind die Bauteile zumindest eine erste und eine zweite Folie oder weisen zumindest einen ersten und einen zweiten Folienabschnitt auf, die zumindest im Fügebereich aneinander liegen.

Gemäß einem Ausführungsbeispiel ist es möglich, jedoch nicht zwingend, dass die erste und zweite Folie bzw. der erste und zweite Folienabschnitt großflächig in Anlage zueinander sind.

Es ist bevorzugt, dass die Folien bzw. die Folienabschnitte Papier und/oder Kunststoff und/oder Metall aufweisen. Es ist bevorzugt, dass die Folien bzw. die Folienabschnitte unbeschichtet oder beschichtet sind und/oder einen Sandwich-Aufbau aufweisen.

Gemäß einem bevorzugten Ausführungsbeispiel weisen die Folien bzw. die Folienabschnitte jeweils eine Dicke in einem Bereich größer 0 µm bis ca. 300 µm auf.

In bevorzugter Weise sind vor dem Fügen die erste und die zweite Folie zumindest bereichsweise anhaftend miteinander, insbesondere durch Kleben und/oder Verschweißen verbunden. Ein Fügen der zwei oder mehrerer Folien ohne vorheriges Aneinanderhaften ist jedoch ebenso denkbar. Ein vorheriges Aneinanderhaften vergrößert in vorteilhafter Weise die bereits hohen Haltekräfte der erfindungsgemäßen Verbindung. Gemäß einem weiteren bevorzugten Ausführungsbeispiel weist eine erste Folie eine elektrisch leitende Schicht auf, und eine zweite Folie weist eine elektrisch leitende Schicht auf, die elektrische leitende Schicht der ersten Folie und die elektrisch leitende Schicht der zweiten Folie sind elektrisch gegeneinander isoliert, und durch die Durchsetzbewegung des Vorsprunges im Fügebereich der ersten und zweiten Folie wird ein elektrischer Kontakt zwischen der elektrisch leitenden Schicht der ersten Folie und der elektrisch leitenden Schicht der zweiten Folie geschaffen.

In bevorzugter Weise besteht das Trägerelement aus einer Trägerfolie, die zumindest im Fügebereich mit der ersten Folie in Anlage ist. In bevorzugter Weise sind die erste Folie und die Trägerfolie großflächig in Anlage zueinander.

Bei dem zuvor beschriebenen Verfahren weist die Trägerfolie vorzugsweise Papier und/oder Kunststoff und/oder Metall auf. Hierbei kann die Trägerfolie unbeschichtet oder beschichtet sein und/oder einen Sandwich-Aufbau aufweisen. Es ist wünschenswert, daß die Trägerfolie eine Dicke in einem Bereich größer 0 µm bis ca. 300 µm aufweist.

Weiterhin ist es möglich, daß vor dem Fügen die Trägerfolie mit der ersten Folie zumindest bereichsweise anhaftend, insbesondere durch Kleben und/oder Verschweißen, verbunden ist. Die erste Folie ist vorzugsweise zumindest in dem Fügebereich mit der Trägerfolie beschichtet.

In besonders bevorzugter Weise weist der Fügebereich der ersten und zweiten Folie eine Größe von ca. 1 mm² auf.

Gemäß einem bevorzugten Ausführungsbeispiel ist der Vorsprung als Mikrostruktur auf einem Fügestempel oder einem Gegenhalter ausgebildet.

Gemäß einem bevorzugten Ausführungsbeispiel weist die Mikrostruktur eine Breite und eine Höhe von jeweils kleiner 1 mm auf.

In bevorzugter Weise ist der Vorsprung stegförmig ausgebildet. In bevorzugter Weise sind eine Mehrzahl, insbesondere drei, von Vorsprüngen für einen einzigen Fügebereich zur parallelen Durchsetzung von Material vorgesehen. Gemäß einem bevorzugten Ausführungsbeispiel sind zumindest zwei, insbesondere drei, stegförmige Vorsprünge parallel zueinander für einen einzigen Fügebereich vorgesehen.

Hierbei ist es vorteilhaft, wenn die Krafteinleitung auf die Vorsprünge über einen Stempel und/oder einen Gegenhalter schlagartig erfolgt.

Gemäß dem Vorrichtungsaspekt wird diese Aufgabe erfindungsgemäß gelöst durch eine Vorrichtung zum Fügen von zumindest zwei Bauteilen, die zumindest in einem Fügebereich in Anlage miteinander gebracht sind, mit zumindest einem Vorsprung und einem entgegengesetzten Gegenhalter, wobei der Vorsprung zum Durchsetzen der Bauteile im Fügebereich vorgesehen ist, ein Trägerelement zwischen einem ersten der zwei Bauteile und dem Gegenhalter vorgesehen und mit dem ersten Bauteil und dem Gegenhalter zumindest in dem Fügebereich in Anlage ist, und der Gegenhalter zum flächigen Abstützen des Trägerelementes zumindest in dem Fügebereich gegen die Durchsetzbewegung des Vorsprunges vorgesehen ist, und das Durchsetzen des Vorsprunges durch die Bauteile und die entgegengesetzte flächige Abstützung des Trägerelementes eine plastische Verformung des durchgesetzten Materials der Bauteile in Richtung quer zu der Relativbewegung des Vorsprunges unter Verformung des Trägerelementes bewirkt.

Bei der Vorrichtung zum Fügen ist es bevorzugt, dass das Trägerelement aus einem elastischen und/oder plastisch-verformbaren Werkstoff besteht.

In bevorzugter Weise ist der Vorsprung relativ in Richtung auf den Gegenhalter bewegbar.

Gemäß einem bevorzugten Ausführungsbeispiel der Vorrichtung zum Fügen weist der Vorsprung zumindest eine Schneidkante auf, um bei der Durchsetzbewegung durch die Bauteile einen partiellen Schneidvorgang an beiden Bauteilen entlang zumindest einer Linie durchführt. In bevorzugter Weise ist die Schneidkante eine Gerade. Es ist bevorzugt, dass der Vorsprung zwei parallele Schneidkanten aufweist, wobei die Schneidkanten durch eine beliebig gestaltete weitere Schneidkante, z.B. mittels einer Geraden oder eines Kreisbogens erbunden sein können.

In bevorzugter Weise ist der Gegenhalter als eine ebene Gegenhalterplatte ausgebildet, die mit dem Trägerelement in Anlage bringbar ist.

Mit der Vorrichtung zum Fügen ist es bevorzugt, dass die Bauteile zumindest eine erste und eine zweite Folie sind oder zumindest einen ersten und einen zweiten Folienabschnitt aufweisen, die zumindest im Fügebereich aneinander liegen, und das Trägerelement aus einer Trägerfolie besteht, die zumindest im Fügebereich mit der ersten Folie in Anlage ist. Auch ist es möglich, daß die erste Folie (in diesem Bereich) mit der Trägerfolie beschichtet ist.

Es ist bevorzugt, dass die Trägerfolie Papier und/oder Kunststoff aufweist. Es ist weiterhin bevorzugt, dass die Trägerfolie unbeschichtet oder beschichtet ist und/oder einen Sandwich-Aufbau aufweist. Es ist bevorzugt, dass die Trägerfolie eine Dicke in einem Bereich größer 0 µm bis ca. 300 µm aufweist.

Gemäß einem bevorzugten Ausführungsbeispiel der Vorrichtung zum Fügen ist der Vorsprung als Mikrostruktur auf einem bewegbaren Fügestempel oder dem Gegenhalter ausgebildet.

Bei der Vorrichtung zum Fügen ist es bevorzugt, dass der bewegbare Fügestempel in einem Niederhalter geführt ist.

Gemäß einem bevorzugten Ausführungsbeispiel der Vorrichtung zum Fügen weist die Mikrostruktur eine Breite und eine Höhen von jeweils kleiner 1 mm auf. Es ist bevorzugt, dass der Fügebereich eine Größe von ca. 1 mm² aufweist.

In bevorzugter Weise ist der Vorsprung stegförmig ausgebildet. Bei der Vorrichtung zum Fügen ist es bevorzugt, dass eine Mehrzahl, insbesondere drei, von Vorsprüngen für einen einzigen Fügebereich zur parallelen Durchsetzung von Material vorgesehen sind. Gemäß einem bevorzugten Ausführungsbeispiel der Vorrichtung sind zumindest zwei, insbesondere drei, stegförmige Vorsprünge parallel zueinander für einen einzigen Fügebereich vorgesehen.

Nachfolgend wird die vorliegende Erfindung anhand eines Ausführungsbeispiels in Verbindung mit den beigefügten Zeichnungen näher beschrieben und erläutert. In den Zeichnungen zeigen:
- Fig. 1: die schematische Darstellung einer Vorrichtung zum Fügen von zwei Bauteilen gemäß einem Ausführungsbeispiel, und
- Fig. 2: die Schnittansicht einer Fügeverbindung.

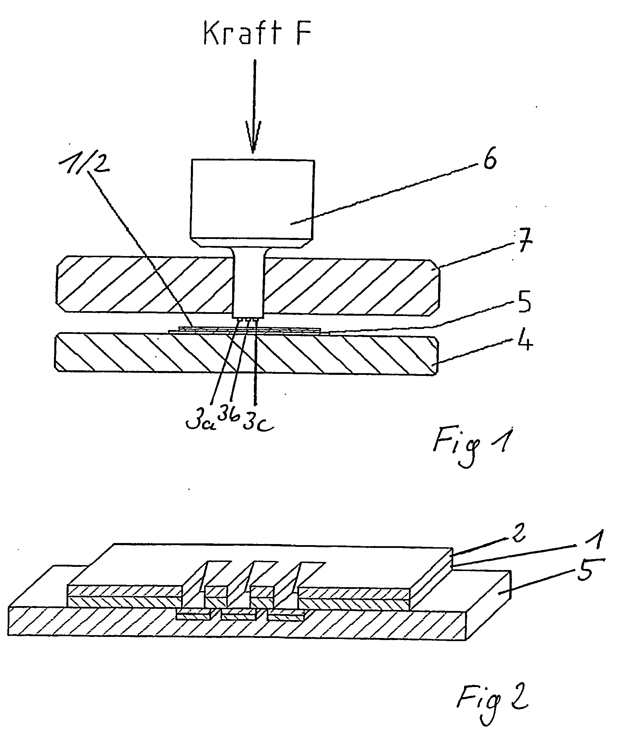

Fig. 1 zeigt die Vorrichtung zum Fügen von zwei Bauteilen. Gemäß dem gezeigten Ausführungsbeispiel sind zwei plattenförmige Bauteile in Form zweier Folien 1, 2 in der Fügevorrichtung gezeigt. Diese Folien 1, 2 liegen zumindest im Fügebereich aufeinander. Eine erste Folie 1 liegt auf einer Trägerfolie 5, die als Trägerelement dient. Die Trägerfolie 5 liegt wiederum auf einem plattenförmigen Amboss, der als Gegenhalter 4 ausgebildet ist. Der plattenförmige Amboss weist eine ebene Gegenhalterfläche auf.

Der zweiten der beiden Folien 1, 2 gegenüberliegend ist ein Niederhalter 7 und ein Fügestempel 6 vorgesehen. Der Fügestempel 6 ist in einer Öffnung des Niederhalters 7 axial bewegbar angeordnet. Der bewegbare Fügestempel 6 ist in dem Niederhalter 7 geführt. Der Niederhalter 7 weist eine ebene Niederhalterfläche auf. Der Niederhalter 7 ist in Richtung der Stempelbewegung bewegbar und wird mit der zweiten Folie 2 in Kontakt gebracht. Die erste Folie 1, die zweite Folie 2, die Trägerfolie 5, die Gegenhalterfläche des Amboss 4 und die Niederhalterfläche des Niederhalters 7 sind im wesentlichen parallel zueinander angeordnet, wie dies in Fig. 1 gezeigt ist.

In der Vorrichtung zum Fügen der zwei Folien 1, 2, sind diese zumindest im Fügebereich in Anlage miteinender gebracht. Der Fügestempel 6 weist Vorsprünge 3a-c auf, die sich in Richtung auf den als Gegenhalter 4 ausgebildeten Amboss erstrecken. Die Vorsprünge 3a-c sind als Mikrostruktur auf dem bewegbaren Fügestempel 6 ausgebildet. In dem gezeigten Ausführungsbeispiel sind drei Vorsprunge 3a, 3b, 3c verwendet. Die Mikrostruktur (die drei Vorsprunge) weist eine Breite und eine Höhen von jeweils kleiner 1 mm auf.

Alternativ zu dem gezeigten Ausführungsbeispiel kann die Mikrostruktur auch auf dem Gegenhalter ausgebildet sein. In diesem Fall ist der Fügestempel mit einer ebenen Gegenfläche ausgebildet und die Folien 1, 2 und 5 werden in entgegengesetzter Reihenfolge angeordnet.

In beiden Fällen ist das Gegenstück zur Mikrostruktur nicht als Matrize, d. h. mit einer speziellen Gegenform, sondern bevorzugterweise flach bzw. eben ausgebildet. Der Anlagenaufbau wird dadurch wesentlich vereinfacht und bildet somit die Basis einer hohen Prozeßsicherheit.

Die Vorsprünge 3a-c sind zum Durchsetzen der beiden Folien 1, 2 im Fügebereich vorgesehen. Die Trägerfolie 5 ist zwischen der ersten Folie 1 und dem Gegenhalter 4 vorgesehen. Der Fügestempel 6 mit den Vorsprüngen 3a-c wird entlang seiner Längsachse auf die Folien 1, 2 und 5 zu bewegt und führt eine Durchsetzbewegung relativ in Richtung auf den Gegenhalter 4 aus, wie nachfolgend noch im Detail erläutert wird.

Der Gegenhalter 4 stützt die Trägerfolie 5 im Fügebereich gegen die Durchsetzbewegung der Vorsprünge 3a-c ab. Das Durchsetzen der Vorsprünge 3a-c durch die Folien 1,2 und die entgegengesetzte flächige Abstützung der Trägerfolie 5 bewirken eine plastische Verformung des durchgesetzten Materials der Folien 1, 2 in Richtung quer zu der Relativbewegung der Vorsprünge 3a-c. Dabei wird die Trägerfolie 5 entsprechend verformt, d.h. verdrängt.

Die Trägerfolie 5 besteht aus einem elastischen und/oder plastisch-verformbaren Werkstoff. Beispielsweise weist die Trägerfolie 5 Papier und/oder Kunststoff und/oder Metall auf. Die Trägerfolie 5 kann unbeschichtet oder beschichtet sein und/oder einen Sandwich-Aufbau aufweisen.

Gemäß dem Ausführungsbeispiel weisen Vorsprünge 3a-c jeweils Schneidkanten auf. Diese Schneidkanten führen bei der Durchsetzbewegung durch die Folien 1, 2 einen partiellen Schneidvorgang an beiden Folien 1, 2 aus, wie dies in Fig. 2 gezeigt ist. Jeder der Vorsprünge 3a-c weist zwei parallele gerade Schneidkanten auf. Die Trägerfolie 5 weist eine Dicke in einem Bereich größer 0 µm bis ca. 300 µm auf.

Die Vorrichtung zum Fügen der Folien 1, 2 definiert den Fügebereich mit einer Größe von ca. 1 mm². Der Fügebereich wird durch die Vorsprünge 3a-c in der Mikrostruktur festgelegt. In dem gezeigten Ausführungsbeispiel sind drei, stegförmige Vorsprünge 3a-c parallel zueinander für einen einzigen Fügebereich vorgesehen.

Beim Fügen der Folien 1, 2 werden diese an einer Mehrzahl von Fügebereichen miteinander verbunden um beispielsweise ein RFID-Etikett herzustellen. Dabei werden die Folien 1, 2 relativ zum Fügestempel 6 entsprechend positioniert. Für diese Positionierung ist der Amboss 4 zusammen mit den Folien 1, 2 und 5 in der Ebene parallel zu den Folien bewegbar um die einzelnen Fügebereiche unter dem Fügestempel 6 zu positionieren. Dabei ist der Fügestempel 6 und der Niederhalter 7 fest bezüglich der genannten Ebene und nur senkrecht zu dieser bewegbar.

Alternativ dazu kann auch der Fügestempel 6 und der Niederhalter 7 in der Ebene parallel zu den Folien bewegbar ausgebildet sein um den Fügestempel 6 über den einzelnen Fügebereichen zu positionieren. Dabei ist der Amboss 4 fest bezüglich der genannten Ebene.

Eine weitere Alternative stellt die Verschiebung der Folien 1, 2 und 5 zwischen einem festen Amboß und einem festen Stempel dar. Dies kann manuell, teilautomatisiert und vollautomatisiert erfolgen.

Die Bewegung des Amboss 4 bzw. des Fügestempels 6 in der Ebene parallel zu den Folien 1, 2 wird durch eine Steuereinrichtung (nicht gezeigt) gesteuert und mit der Durchsetzbewegung des Fügestempels 6 synchronisiert. Dieser Füge-Prozess wird vollautomatisch oder teilautomatisch durchgeführt.

Um die Prozessgeschwindigkeit zu erhöhen, können sowohl der Fügestempel 6 und der Niederhalter 7 als auch der Amboss 4 in der Ebene parallel zu den Folien bewegbar sein. Diese überlagerte Bewegung verkürzt die Positionierzeit zwischen zwei Fügungen und wird durch eine Steuereinrichtung vollautomatisch gesteuert.

Nachfolgend wird das Verfahren zum Fügen der zwei Folien 1, 2 näher beschrieben. Die zwei Folien 1, 2 werden zumindest in einem Fügebereich in Anlage miteinender gebracht. Bei dem gezeigten Ausführungsbeispiel sind die Folien 1, 2 großflächig aufeinander gelegt. Die beiden Folien 1, 2 werden auf die Trägerfolie 5 gelegt und dieses Folienpaket wird in die oben beschriebene Vorrichtung eingelegt. Dabei liegt das Folienpaket großflächig auf der Gegenhalterfläche des Amboss 4. Die Trägerfolie 5 ist dabei zwischen der ersten Folie 1 und dem Amboss 4 angeordnet, wie in Fig. 1 gezeigt.

Der Fügestempel 6 wird in Richtung auf das Folienpaket bewegt, wobei die Vorsprünge 3a-c in die zweite Folie 2 eindringen und Material der zweiten Folie 2 in Richtung auf die erste Folie 1 verdrängen. Gleichzeitig wird Material der ersten Folie 1 in Richtung zu der Trägerfolie 5 verdrängt. Dabei drücken die Vorsprünge 3a-c das verdrängte Material der zweiten Folie 2 auf die erste Folie 1, wodurch das verdrängte Material der ersten Folie 1 in die Trägerfolie 5 eindringt und Material der Trägerfolie 5 verdrängt. Durch die ebene Gegenhalterfläche des Amboss 4 wird die Trägerfolie 5 entgegen der Bewegung des Fügestempels 6 (der Bewegung der Vorsprünge) abgestützt, so dass eine weitere Verdrängung von Material in Richtung der Bewegung des Fügestempels 6 im Wesentlichen verhindert wird.

Bei der Verdrängung des Materials der zweiten und der ersten Folie 1, 2 in Richtung der Bewegung des Fügestempels 6 mit der Kraft F führt der Fügestempel 6 (die Vorsprunge 3a-c) eine Durchsetzbewegung aus. Wie in Fig. 2 gezeigt, wird das Material der zweiten Folie 2, das durch die Vorsprunge 3a-c verdrängt wird, in Richtung des Gegenhalters 4 soweit verdrängt, bis ein Abschnitt dieses verdrängten Materials der zweiten Folie 2 im wesentlichen vollständig außerhalb der Ebene der ersten Folie 1 und im wesentlichen vollständig innerhalb der Trägerfolie 5 ist. Dementsprechend ist ein Abschnitt des verdrängten Materials der ersten Folie 1 weit in die Trägerfolie 5 hinein verdrängt.

Die ebene Gegenhalterfläche des Amboss 4 stützt die Trägerfolie 5 entgegen die Durchsetzbewegung des Fügestempels 6 (die Durchsetzbewegung der Vorsprünge) ab. Dadurch wird eine weitere Verdrängung von Material in Richtung der Bewegung des Fügestempels 6 im Wesentlichen verhindert. Die Durchsetzbewegung des Fügestempels mit der vorgegeben Kraft F wird jedoch fortgesetzt, so dass eine plastische Verformung des durchgesetzten Materials der Folien 1, 2 quer zur Durchsetzbewegung eintritt und ein Hinterschneidungsbereich mit der ersten und der zweiten Folien 1, 2 gebildet wird, wie dies in Fig. 2 gezeigt ist. Durch die Querverquetschung des verdrängten Materials der zweiten und der ersten Folie 1, 2 in der Trägerfolie 5 wird ein formschlüssige Verbindung der Folien 1, 2 im Fügebereich geschaffen.

Die erläuterte Durchsetzbewegung des Fügestempels 6 wird in einem Hub durchgeführt. Diese einzige kontinuierliche Hubbewegung erlaubt einen schnellen Fügeprozess pro Fügebereich.

Die Folien 1, 2 weisen jeweils eine Dicke in einem Bereich größer 0 µm bis ca. 300 µm auf. Die Vorsprünge 3a-c der Mikrostruktur weisen eine Höhen von kleiner 1 mm auf. Um die beschrieben Durchsetzbewegung durchzuführen muß die Höhe der Vorsprünge 3a-c der Mikrostruktur größer als die gesamte Dicke der beiden Folien sein.

Wie in Fig. 2 gezeigt, führen die Vorsprünge 3a-c bei der Durchsetzbewegung durch die Folien 1, 2 einen partiellen Schneidvorgang an beiden Folien 1, 2 durch. Dazu weisen die Vorsprünge 3a-c die bereits erwähnten Schneidkanten auf. Gemäß dem Ausführungsbeispiel erfolgt der Schneidvorgang durch jeden der Vorsprünge 3a-c entlang zweier paralleler Geraden. Durch diesen partiellen Schneidvorgang wird das zu verdrängende Material von der übrigen Folie teilweise getrennt. Dadurch wird die Durchsetzverdrängung des Materials erleichtert. Weiterhin wird entlang der Schneidkanten die Querverquetschung des verdrängten Materials der Folien 1, 2 in die Trägerfolie 5 nicht behindert, so dass sich die Hinterschneidung bei geringem Kraftaufwand und in zuverlässiger Weise bildet. Die Verbindung des verdrängten Materials der Folien bzw. des Hinterschneidungsbereiches jeweils mit der übrigen Folie 1, 2 wird über den nicht geschnitten Stegbereich aufrechterhalten, wie dies in Fig. 2 gezeigt ist.

Beim Fügen der zwei Folien 1, 2 wird der vorangehend beschriebene Fügeprozess für mehrere Fügebereiche nacheinender oder mittels einer Vorrichtung mit einer Mehrzahl von Fügestempeln gleichzeitig durchgeführt. Der Fügebereich weist eine Größe von ca. 1 mm² auf. Die einfache Hubbewegung und das Zusammenwirken der Vorsprünge mit einem einfachen ebenen Gegenhalter erlaubt eine zuverlässige Fügung bei einer kurzen Prozesszeit.

In der vorangehend beschrieben Vorrichtung und in dem Verfahren ist das Fügen von zwei Folien 1, 2 gezeigt. Diese Vorrichtung bzw. dieses Verfahren ist auch zum Fügen von Folienabschnitten geeignet, die mit Bauteilen verbunden sind.

In der vorangehend beschrieben Vorrichtung und in dem Verfahren ist die Trägerfolie 5 als dritte Folie des Folienpakets beschrieben. Diese Trägerfolie 5 ist je nach Einsatzbereich als verlorenes Hilfsteil ausgebildet, das nach dem Fügen der Folien 1, 2 entfernt (abgezogen) wird, oder als Produktteil der gefügten Folien ausgebildet, das an den Folien verbleibt. Für die Trägerfolie 5 ist es wesentlich, dass diese aus einem elastischen und/oder plastisch-verformbaren Werkstoff besteht, um das verdrängte und in Querrichtung verquetschte Material der Folien 1, 2 aufzunehmen.

Die Trägerfolie 5 kann je nach Einsatzzweck aus Papier, Kunststoff oder Metall bestehen. Weiterhin kann die Trägerfolie aus einem Verbund der genannten Werkstoffe gebildet werden. Die Trägerfolie 5 ist unbeschichtet oder beschichtet. Die Trägerfolie 5 weist eine Dicke in einem Bereich größer 0 µm bis ca. 300 µm auf. Dabei kann die Dicke der Trägerfolie 5 gleich oder ungleich der jeweiligen Dicke der Folien 1, 2 sein.

Die Trägerfolie 5 kann je nach Einsatzzweck und Ausführungsform vor dem Fügen mit der ersten Folie 1 durch Kleben und/oder Verschweißen verbunden sein. Alternativ dazu ist die erste Folie 1 mit der Trägerfolie 5 beschichtet.

Die verwendeten Folien 1, 2 bzw. die Folienabschnitte bestehen aus Papier, Kunststoff oder Metall oder sind aus einem Verbund dieser Werkstoffe gebildet. Weiterhin können unbeschichtete oder beschichtete Folien 1, 2 bzw. die Folienabschnitte gefügt werden. Auch auf Folien mit einem Sandwich-Aufbau ist das Verfahren zum Fügen anwendbar.

Jede der Folien 1, 2 bzw. die Folienabschnitte weist eine Dicke in einem Bereich größer 0 µm bis ca. 300 µm auf. Dabei können Folien gleicher oder unterschiedlicher Dicke gefügt werden.

Die Folien können je nach Einsatzzweck und Ausführungsform vor dem Fügen zumindest bereichsweise anhaftend miteinander, insbesondere durch Kleben und/oder Verschweißen verbunden werden. Die Fügung liefert somit eine zusätzlich formschlüssige Verbindung.

Die gefügten Folien werden beispielsweise auf dem Gebiet der Radiofrequenzidentifikation als sogenannte RFID-Datenträger in Form von RFID-Etiketten verwendet, die aus flexiblem Antennensubstrat mit Metallbeschichtung und vormontierten RFID-Chips auf Metallfolienbrücken bestehen. Dabei können bei Erfordernis eines entsprechenden Anwendungsfalles die erste Folie 1 eine elektrisch leitende Schicht und die zweite Folie 2 ebenfalls eine elektrisch leitende Schicht aufweisen. Die elektrisch leitende Schicht der ersten Folie 1 und die elektrisch leitende Schicht der zweiten Folie 2 sind hierbei z.B. durch eine (weitere) Isolierfolie elektrisch gegeneinander isoliert. Durch das Durchsetzfügen im Fügebereich der ersten und zweiten Folie 1, 2 wird ein elektrischer Kontakt zwischen der elektrisch leitenden Schicht der ersten Folie 1 und der elektrisch leitenden Schicht der zweiten Folie 2 geschaffen wird. Somit können gezielt Leiterbahnen auf den Folien miteinander verbunden werden.

Mit dem beschrieben Verfahren zum Fügen von Folien können Verbindungen für die Mikrosystemtechnik, Präzisionstechnik, Elektronik und Elektrotechnik für eine große Vielfalt von Werkstoffen erzeugt werden. Es ist der Einsatz von Folien mit unterschiedlichen Dicken möglich. Es sind Werkstoffkombinationen möglich (auch mit Kunststoffen und mit Kunststoffschichten). Es ist das Fügen von zwei Folien dargestellt. Es können mit dem Verfahren auch eine Mehrzahl von Folien miteinander verbunden werden.

Bei dem Verfahren ist keine Oberflächenvorbehandlung der zu fügenden Bauteile erforderlich. Es sind keine Zusatzwerkstoffe bzw. keine Hilfsfügeteile wie Nieten und dgl. erforderlich. Es ist keine Nachbehandlung oder Nachbearbeitung erforderlich. Bei dem beschriebenen Verfahren erfolgt kein Wärmeeintrag in die Fügeteile.

Das Verfahren weist eine hohe Wirtschaftlichkeit und Prozesssicherheit auf. Es sind Taktzeiten weit unter einer Sekunde möglich. Das Verfahren kann mit weiteren Verfahren (z.B. Kleben) kombiniert werden.

Das Ausführungsbeispiel beschreibt ein Verfahren zum Fügen von zumindest zwei Bauteilen 1, 2, die zumindest in einem Fügebereich in Anlage miteinender gebracht sind. Ein Trägerelement 5 ist mit einem ersten 1 der zwei Bauteile 1, 2 zumindest in dem Fügebereich in Anlage. Zumindest ein Vorsprung 3a-c durchsetzt die Bauteile 1, 2 im Fügebereich in Richtung zu dem Trägerelement 5. Das Trägerelement 5 wird zumindest in dem Fügebereiche gegen die Durchsetzbewegung des Vorsprunges 3a-c flächig abgestützt.

Das Durchsetzen des Vorsprunges 3a-c durch die Bauteile 1, 2 und die entgegengesetzte flächige Abstützung des Trägerelementes 5 bewirkt eine plastische Verformung des durchgesetzten Materials der Bauteile 1, 2 in Richtung quer zu der Durchsetzbewegung des Vorsprunges 3a-c unter Verformung des Trägerelementes 5.

Bei dem Verfahren zum Fügen von zumindest zwei Bauteilen dringt der Vorsprung 3a-c in ein zweites Bauteil 2 ein. Material des zweiten Bauteils 2 wird in Richtung auf das erste Bauteil 1 verdrängt. Durch die Durchsetzbewegung des Vorsprunges 3a-c wird Material des ersten Bauteils 1 in Richtung auf das Trägerelement 5 verdrängt. Das verdrängte Material des ersten und des zweiten Bauteils 1, 2 dringt im Wesentlichen in das Trägerelement 5 ein. Die plastische Verformung des durchgesetzten Materials der Bauteile 1, 2 bildet quer zur Durchsetzbewegung einen Hinterschneidungsbereich mit dem ersten und dem zweiten Bauteil.

Der Vorsprung 3a-c gemäß dem Ausführungsbeispiel führt bei der Durchsetzbewegung durch die Bauteile 1, 2 einen partiellen Schneidvorgang an beiden Bauteilen 1, 2 entlang zumindest einer Linie durch. Dieser Schneidvorgang erfolgt entlang zumindest einer Geraden und gemäß dem Ausführungsbeispiel entlang zweier paralleler Geraden für einen Vorsprung. Die Durchsetzbewegung des Vorsprunges 3a-c erfolgt in einer einzigen kontinuierlichen Hubbewegung.

Bei dem beschriebenen Verfahren zum Fügen erfolgt die flächige Abstützung des Trägerelementes 5 in einer Ebene, insbesondere großflächig.

Gemäß des Ausführungsbeispieles sind die genannten Bauteile zumindest eine erste und eine zweite Folie 1, 2 oder weisen zumindest einen ersten und einen zweiten Folienabschnitt auf, die zumindest im Fügebereich aneinander liegen. Diese erste und zweite Folie 1, 2 bzw. der erste und zweite Folienabschnitt sind großflächig in Anlage zueinander.

Die Folien 1, 2 bzw. die Folienabschnitte können Papier und/oder Kunststoff und/oder Metall aufweisen. Weiterhin können die Folien 1, 2 bzw. die Folienabschnitte unbeschichtet oder beschichtet sein und/oder einen Sandwich-Aufbau aufweisen. Die Folien 1, 2 bzw. die Folienabschnitte gemäß dem Ausführungsbeispiel weisen jeweils eine Dicke in einem Bereich größer 0 µ bis ca. 300 µm auf. Vor dem Fügen können die erste und die zweite Folie 1, 2 zumindest bereichsweise anhaftend miteinander, insbesondere durch Kleben und/oder Verschweißen verbunden sein.

Gemäß eines bevorzugten Einsatzbereiches weisen die erste Folie 1 und die zweite Folie 2 jeweils eine elektrisch leitende Schicht auf. Die elektrisch leitende Schicht der ersten Folie 1 und die elektrisch leitende Schicht der zweiten Folie 2 können bei Erfordernis des entsprechenden Anwendungsfalles zunächst elektrisch gegeneinander isoliert sein. Die Durchsetzbewegung des Vorsprunges 3a-c im Fügebereich der ersten und zweiten Folie 1, 2 schafft einen elektrischen Kontakt zwischen der elektrisch leitenden Schicht der ersten Folie 1 und der elektrisch leitenden Schicht der zweiten Folie 2.

Das Trägerelement besteht aus einem elastischen und/oder plastisch-verformbaren Werkstoff und ist als Trägerfolie 5 ausgebildet, die zumindest im Fügebereich mit der ersten Folie 1 in Anlage ist. Gemäß dem Ausführungsbeispiel sind die erste Folie 1 und die Trägerfolie 5 großflächig in Anlage zueinander.

Die Trägerfolie 5 weist Papier und/oder Kunststoff und/oder Metall auf, wobei die Trägerfolie 5 unbeschichtet oder beschichtet und/oder einen Sandwich-Aufbau aufweisen kann. Die Trägerfolie 5 weist eine Dicke in einem Bereich größer 0 µm bis ca. 300 µm auf, und kann vor dem Fügen mit der ersten Folie 1 zumindest bereichsweise anhaftend, insbesondere durch Kleben und/oder Verschweißen verbunden sein. Alternativ kann die erste Folie 1 zumindest in dem Fügebereich mit der Trägerfolie 5 beschichtet sein.

Das beschriebene Ausführungsbeispiel zeigt weiterhin eine Vorrichtung zum Fügen von zumindest zwei Bauteilen. Diese Bauteile sind zumindest in einem Fügebereich in Anlage miteinander gebracht. Diese Vorrichtung weist zumindest einen Vorsprung 3a-c und einen entgegengesetzten Gegenhalter 4 auf, wobei der Vorsprung 3a-c zum Durchsetzen der Bauteile 1, 2 im Fügebereich vorgesehen ist. Ein Trägerelement 5 ist zwischen einem ersten 1 der zwei Bauteile 1, 2 und dem Gegenhalter 4 vorgesehen und mit dem ersten Bauteil (1) und dem Gegenhalter (4) zumindest in dem Fügebereich in Anlage. Der Gegenhalter (4) stützt das Trägerelement 5 zumindest in dem Fügebereiche gegen die Durchsetzbewegung des Vorsprunges 3a-c flächig ab. Das Durchsetzen des Vorsprunges 3a-c durch die Bauteile 1, 2 und die entgegengesetzte flächige Abstützung des Trägerelementes 5 bewirkt die plastische Verformung des durchgesetzten Materials der Bauteile 1, 2 in Richtung quer zu der Relativbewegung des Vorsprunges 3a-c unter Verformung des Trägerelementes 5.

Der Fügebereich weist eine Größe von ca. 1 mm² auf, wobei die Vorsprünge 3a-c als Mikrostruktur auf einem Fügestempel (6) oder einem Gegenhalter ausgebildet sind. Diese Mikrostruktur weist eine Breite und eine Höhe von jeweils kleiner 1 mm auf. Der Vorsprung ist 3a-c stegförmig ausgebildet, wobei eine Mehrzahl, insbesondere drei, Vorsprünge (3a-c) für einen einzigen Fügebereich zur parallelen Durchsetzung von Material vorgesehen sind. Diese stegförmigen Vorsprünge 3a-c sind parallel zueinander für einen einzigen Fügebereich vorgesehen.

## Patentansprüche

1. Verfahren zum Fügen von zumindest zwei Bauteilen (1, 2), die zumindest in einem Fügebereich in Anlage miteinender gebracht sind, wobei ein Trägerelement (5) mit einem ersten (1) der zwei Bauteile (1,2) zumindest in dem Fügebereich in Anlage ist, zumindest ein Vorsprung (3a-c) die Bauteile (1, 2) im Fügebereich in Richtung zu dem Trägerelement (5) durchsetzt, das Trägerelement (5) zumindest in dem Fügebereiche gegen die Durchsetzbewegung des Vorsprunges (3a-c) flächig abgestützt wird, und das Durchsetzen des Vorsprunges (3a-c) durch die Bauteile (1, 2) und die entgegengesetzte flächige Abstützung des Trägerelementes (5) eine plastische Verformung des durchgesetzten Materials der Bauteile (1, 2) in Richtung quer zu der Durchsetzbewegung des Vorsprunges (3a-c) unter Verformung des Trägerelementes (5) bewirkt.

2. Verfahren zum Fügen von zumindest zwei Bauteilen nach Anspruch 1, **dadurch gekennzeichnet, daß** das Trägerelement (5) aus einem elastischen und/oder plastisch-verformbaren Werkstoff besteht.

3. Verfahren zum Fügen von zumindest zwei Bauteilen nach Anspruch 1 oder 2, **dadurch gekennzeichnet, daß** der Vorsprung (3a-c) in ein zweites Bauteil (2) eindringt und Material des zweiten Bauteils (2) in Richtung auf das erste Bauteil (1) verdrängt, und Material des ersten Bauteils (1) in Richtung auf das Trägerelement (5) verdrängt wird, und das verdrängte Material des ersten und des zweiten Bauteils (1, 2) im wesentlichen in das Trägerelement (5) eindringt, wobei die plastische Verformung des durchgesetzten Materials der Bauteile (1, 2) quer zur Durchsetzbewegung einen Hinterschneidungsbereich mit dem ersten und dem zweiten Bauteil (1, 2) bildet.

4. Verfahren zum Fügen von zumindest zwei Bauteilen nach zumindest einem der Ansprüche 1 bis 3, **dadurch gekennzeichnet, daß** der Vorsprung (3a-c) bei der Durchsetzbewegung durch die Bauteile (1, 2) einen partiellen Schneidvorgang an beiden Bauteilen (1, 2) entlang zumindest einer Linie durchführt, wobei vorzugsweise der Schneidvorgang entlang zumindest einer, und weiterhin vorzugsweise zumindest entlang zweier paralleler Geraden erfolgt.

5. Verfahren zum Fügen von zumindest zwei Bauteilen nach zumindest einem der Ansprüche 1 bis 4, **dadurch gekennzeichnet, daß** die Durchsetzbewegung des Vorsprunges (3a-c) in einer einzigen kontinuierlichen Hubbewegung erfolgt und/oder daß die flächige Abstützung des Trägerelementes (5) in einer Ebene erfolgt, wobei vorzugsweise jeweils die Abstützung des Trägerelementes (5) großflächig erfolgt.

6. Verfahren zum Fügen von zumindest zwei Bauteilen nach zumindest einem der Ansprüche 1 bis 5, **dadurch gekennzeichnet, daß** die Bauteile zumindest eine erste und eine zweite Folie (1, 2) sind oder zumindest einen ersten und eine zweiten Folienabschnitte aufweisen, die zumindest im Fügebereich aneinander liegen, wobei vorzugsweise die erste und zweite Folie (1, 2) bzw. der erste und zweite Folienabschnitt großflächig in Anlage zueinander sind und/oder die Folien (1, 2) bzw. die Folienabschnitte Papier und/oder Kunststoff und/oder Metall aufweisen, und/oder die Folien (1, 2) bzw. die Folienabschnitte unbeschichtet oder beschichtet sind und/oder einen Sandwich-Aufbau aufweisen.

7. Verfahren zum Fügen von zumindest zwei Bauteilen nach Anspruch 6, **dadurch gekennzeichnet, daß** die Folien (1, 2) bzw. die Folienabschnitte jeweils eine Dicke in einem Bereich größer 0 µm bis ca. 300 µm aufweisen und/oder daß vor dem Fügen die erste und die zweite Folie (1, 2) zumindest bereichsweise anhaftend miteinander, insbesondere durch Kleben und/oder Verschweißen verbunden sind.

8. Verfahren zum Fügen von zumindest zwei Bauteilen nach zumindest einem der Ansprüche 6 oder 7, **dadurch gekennzeichnet, daß** die erste Folie (1) eine elektrisch leitende Schicht aufweist und die zweite Folie (2) eine elektrisch leitende Schicht aufweist, wobei die elektrische leitende Schicht der ersten Folie (1) und die elektrisch leitende Schicht der zweiten Folie (2) vorzugsweise elektrisch gegeneinander isoliert sind, und durch die Durchsetzbewegung des Vorsprunges (3a-c) im Fügebereich der ersten und zweiten Folie (1, 2) ein elektrischer Kontakt zwischen der elektrisch leitenden Schicht der ersten Folie (1) und der elektrisch leitenden Schicht der zweiten Folie (2) geschaffen wird.

9. Verfahren zum Fügen von zumindest zwei Bauteilen nach zumindest einem der Ansprüche 6 bis 8, **dadurch gekennzeichnet, daß** das Trägerelement aus einer Trägerfolie (5) besteht, die zumindest im Fügebereich mit der ersten Folie (1) in Anlage ist, wobei vorzugsweise die erste Folie (1) und die Trägerfolie (5) großflächig in Anlage zueinander sind.

10. Verfahren zum Fügen von zumindest zwei Bauteilen nach Anspruch 9, **dadurch gekennzeichnet, daß** die Trägerfolie (5) Papier und/oder Kunststoff und/oder Metall aufweist und/oder die Trägerfolie (5) unbeschichtet oder beschichtet ist und/oder einen Sandwich-Aufbau aufweist, wobei jeweils vorzugsweise die Trägerfolie (5) eine Dicke in einem Bereich größer 0 µm bis ca. 300 µm aufweist.

11. Verfahren zum Fügen von zumindest zwei Bauteilen nach zumindest einem der Ansprüche 9 oder 10, **dadurch gekennzeichnet, daß** vor dem Fügen die Trägerfolie (5) mit der ersten Folie (1) zumindest bereichsweise anhaftend, insbesondere durch Kleben und/oder Verschweißen verbunden ist, und/oder daß die erste Folie (1) zumindest in dem Fügebereich mit der Trägerfolie (5) beschichtet ist.

12. Verfahren zum Fügen von zumindest zwei Bauteilen nach zumindest einem der Ansprüche 6 bis 11, **dadurch gekennzeichnet, daß** der Fügebereich der ersten und zweiten Folie (1, 2) eine Größe von ca. 1 mm² aufweist.

13. Verfahren zum Fügen von zumindest zwei Bauteilen nach zumindest einem der Ansprüche 6 bis 12, **dadurch gekennzeichnet, daß** der Vorsprung (3a-c) als Mikrostruktur auf einem Fügestempel (6) oder einem Gegenhalter ausgebildet ist, wobei vorzugsweise die Mikrostruktur eine Breite und eine Höhe von jeweils kleiner 1 mm aufweist, und/oder daß der Vorsprung (3a-c) stegförmig ausgebildet ist.

14. Verfahren zum Fügen von zumindest zwei Bauteilen nach zumindest einem der Ansprüche 6 bis 13, **dadurch gekennzeichnet, daß** eine Mehrzahl von Vorsprüngen (3a-c) für einen einzigen Fügebereich zur parallelen Durchsetzung von Material vorgesehen sind, wobei vorzugsweise zumindest zwei, insbesondere drei, stegförmige Vorsprünge (3a-c) parallel zueinander für einen einzigen Fügebereich vorgesehen sind.

15. Verfahren zum Fügen von zumindest zwei Bauteilen nach zumindest einem der Ansprüche 1 bis 14, **dadurch gekennzeichnet, daß** die Krafteinleitung auf die Vorsprünge (3a-c) über einen Stempel (6) und/oder einen Gegenhalter (4) schlagartig erfolgt.

16. Vorrichtung zum Fügen von zumindest zwei Bauteilen (1, 2), die zumindest in einem Fügebereich in Anlage miteinander gebracht sind, mit zumindest einem Vorsprung (3a-c) und einem entgegengesetzten Gegenhalter (4), wobei der Vorsprung (3a-c) zum Durchsetzen der Bauteile (1, 2) im Fügebereich vorgesehen ist, ein Trägerelement (5) zwischen einem ersten (1) der zwei Bauteile (1, 2) und dem Gegenhalter (4) vorgesehen und mit dem ersten Bauteil (1) und dem Gegenhalter (4) zumindest in dem Fügebereich in Anlage ist, und der Gegenhalter (4) zum flächigen Abstützen des Trägerelementes (5) zumindest in dem Fügebereiche gegen die Durchsetzbewegung des Vorsprunges (3a-c) vorgesehen ist, und das Durchsetzen des Vorsprunges (3a-c) durch die Bauteile (1, 2) und die entgegengesetzte flächige Abstützung des Trägerelementes (5) eine plastische Verformung des durchgesetzten Materials der Bauteile (1, 2) in Richtung quer zu der Relativbewegung des Vorsprunges (3a-c) unter Verformung des Trägerelementes (5) bewirkt.

17. Vorrichtung zum Fügen von zumindest zwei Bauteilen nach Anspruch 16, **dadurch gekennzeichnet, daß** der Vorsprung (3a-c), der vorzugsweise relativ in Richtung auf den Gegenhalter (4) bewegbar ist, zumindest eine Schneidkante aufweist, um bei der Durchsetzbewegung durch die Bauteile (1, 2) einen partiellen Schneidvorgang an beiden Bauteilen (1, 2) entlang zumindest einer Linie durchführt, wobei vorzugsweise die Schneidkante eine Gerade ist und/oder wobei der Vorsprung (3a-c) zweie parallele Schneidkanten aufweist.

18. Vorrichtung zum Fügen von zumindest zwei Bauteilen nach zumindest einem der Ansprüche 16 oder 17, **dadurch gekennzeichnet, daß** der Gegenhalter (4) als eine ebene Gegenhalterplatte ausgebildet ist, die mit dem Trägerelement (5) in Anlage bringbar ist, und/oder **dadurch**, daß das Trägerelement (5) aus einem elastischen und/oder plastisch-verformbaren Werkstoff besteht.

19. Vorrichtung zum Fügen von zumindest zwei Bauteilen nach zumindest einem der Ansprüche 16 bis 18, **dadurch gekennzeichnet, daß** die Bauteile zumindest eine erste und eine zweite Folie (1, 2) sind oder zumindest einen ersten und einen zweiten Folienabschnitt aufweisen, die zumindest im Fügebereich aneinander liegen, und das Trägerelement aus einer Trägerfolie (5) besteht, die zumindest im Fügebereich mit der ersten Folie (1) in Anlage ist, wobei vorzugsweise die Trägerfolie (5) Papier und/oder Kunststoff und/oder Metall aufweist, und weiterhin vorzugsweise unbeschichtet oder beschichtet ist und/oder einen Sandwich-Aufbau aufweist, und/oder insbesondere eine Dicke in einem Bereich größer 0 µm bis ca. 300 µm aufweist.

20. Vorrichtung zum Fügen von zumindest zwei Bauteilen nach zumindest einem der Ansprüche 16 bis 19, **dadurch gekennzeichnet, daß** der Vorsprung (3a-c) als Mikrostruktur auf einem bewegbaren Fügestempel (6) oder dem Gegenhalter ausgebildet ist, wobei vorzugsweise der bewegbare Fügestempel (6) in einem Niederhalter (7) geführt ist, und/oder wobei die Mikrostruktur eine Breite und eine Höhen von jeweils kleiner 1 mm aufweist und/oder der Fügebereich eine Größe von ca. 1 mm² aufweist.

21. Vorrichtung zum Fügen von zumindest zwei Bauteilen nach zumindest einem der Ansprüche 16 bis 20, **dadurch gekennzeichnet, daß** der Vorsprung (3a-c) stegförmig ausgebildet ist, insbesondere jedoch **dadurch**, daß eine Mehrzahl, insbesondere drei, von Vorsprüngen (3a-c) für einen einzigen Fügebereich zur parallelen Durchsetzung von Material vorgesehen sind, wobei vorzugsweise zumindest zwei, insbesondere drei, stegförmige Vorsprünge (3a-c) parallel zueinander für einen einzigen Fügebereich vorgesehen sind.

## Claims

1. A method for assembling at least two components (1, 2), which are brought to contact each other at least in an assembly portion, wherein a carrier element (5) rests on a first (1) one of the two components (1, 2) at least in the assembly portion, at least one projection (3a-c) passes through the components (1, 2) in the assembly portion in the direction towards the carrier element (5), the carrier element (5) is planarly supported at least in the assembly portion against the passing-through movement of the projection (3a-c), and the passing of the projection (3a-c) through the components (1, 2) and the opposed planar support of the carrier element (5) effects a plastic deformation of the passed-through material of the components (1, 2) in the direction transversely to the passing-through movement of the projection (3a-c) by deforming the carrier element (5).

2. A method for assembling at least two components according to claim 1, **characterized in that** the carrier element (5) consists of an elastically and/or plastically deformable material.

3. A method for assembling at least two components according to claim 1 or 2, **characterized in that** the projection (3a-c) penetrates into a second component (2) and displaces material of the second component (2) in the direction towards the first component (1), and material of the first component (1) is displaced in the direction towards the carrier element (5), and the displaced material of the first and of the second component (1, 2) substantially penetrates into the carrier element (5), wherein the plastic deformation of the passed-through material of the components (1, 2) transversely to the passing-through direction forms an undercut portion with the first and the second component (1, 2).

4. A method for assembling at least two components according to at least one of claims 1 to 3, **characterized in that** the projection (3a-c) during the passing movement through the components (1, 2) carries out a partial cutting process at both components (1, 2) along at least one line, wherein preferably the cutting process is carried out at along at least one and further preferably at least along two parallel straight lines.

5. A method of assembling at least two components according to at least one of claims 1 to 4, **characterized in that** the passing-through movement of the projection (3a-c) is carried out in one single continuous stroke movement, and/or that the planar support of the carrier element (5) is carried out in one plane, wherein preferably the support of the carrier element (5) is carried out across a large surface.

6. A method of assembling at least two components according to at least one of claims 1 to 5, **characterized in that** the components are at least a first and a second foil (1, 2) or comprise at least a first and a second foil section which lie adjacent to each other at least in the assembly portion, wherein preferably the first and the second foil (1, 2) or the first and the second foil section contact each other across a large surface and/or the foils (1, 2) or foil sections comprise paper and/or plastics and/or metal, and/or the foils (1, 2) or the foil sections are uncoated or coated and/or have a sandwich structure.

7. A method for assembling at least two components according to claim 6, **characterized in that** the foils (1, 2) or the foil sections have a thickness in the range larger than 0 µm to approx. 300 µm, and/or before assembly the first and the second foil (1, 2) are connected to one another in an at least partially adhesive manner, particularly by adhesion and/or welding.

8. A method for assembling at least two components according to at least one of claims 6 or 7, **characterized in that** the first foil (1) comprises an electrically conductive layer and the second foil (2) comprises an electrically conductive layer, wherein the electrically conductive layer of the first foil (1) and the electrically conductive layer of the second foil (2) are preferably electrically insulated against each other, and an electrical contact between the electrically conductive layer of the first foil (1) and the electrically conductive layer of the second foil (2) is created by the passing-through movement of the projection (3a-c) in the assembly portion of the first and second foil (1, 2).

9. A method for assembling at least two components according to at least one of claims 6 to 8, **characterized in that** the carrier element consists of a carrier foil (5), which at least in the assembly portion rests on the first foil (1) wherein preferably the first foil (1) and the carrier foil (5) contact each other across a large surface.

10. A method for assembling at least two components according to claim 9, **characterized in that** the carrier foil (5) comprises paper and/or plastics and/or metal and/or the carrier foil (5) is uncoated or coated and/or has a sandwich structure, wherein the carrier foil (5) has a thickness in a range larger than 0 µm to approx. 300 µm.

11. A method for assembling at least two components according to at least one of claims 9 or 10, **characterized in that** before assembly the carrier foil (5) is connected to the first foil (1) in an at least partially adhesive manner, particularly by adhesion and/or welding and/or that the first foil (1) is coated by the carrier foil (5) at least in the assembly portion.

12. A method for assembling at least two components according to at least one of claims 6 to 11, **characterized in that** the assembly portion of the first and second foil (1, 2) has a size of approx. 1 mm².

13. A method for assembling at least two components according to at least one of claims 6 to 12, **characterized in that** the projection (3a-c) is formed as a microstructure on an assembly die (6) or on a counterholder, wherein preferably the microstructure has a width and a height of less than 1 mm and that the projection (3a-c) is formed in a catwalk-shaped manner.

14. A method for assembling at least two components according to at least one of claims 6 to 13, **characterized in that** a plurality of projections (3a-c) are provided for one single assembly portion for parallelly passing through material, wherein preferably at least two, particularly three, catwalk-shaped projections (3a-c) are provided in parallel to each other for one single assembly portion.

15. A method for assembling at least two components according to at least one of claims 1 to 14, **characterized in that** the introduction of power onto the projections (3a-c) is carried out abruptly via a die (6) and/or a counterholder (4).

16. An apparatus for assembling at least two components (1, 2) which are brought to contact each other at least on an assembly portion, comprising at least one projection (3a-c) and an opposed counterholder (4), wherein the projection (3a-c) for passing through the components (1, 2) is provided in the assembly portion, a carrier element (5) between a first (1) one of the two components (1, 2) and the counterholder (4) is provided and contact the first component (1) and the counterholder (4) at least in the assembly portion, and the counterholder (4) is provided for planarly supporting the carrier element (5) at least in the assembly portion against the passing-through movement of the projection (3a-c), and the passing of the projection (3a-c) through the components (1, 2) and the opposed planar support of the carrier element (5) effects a plastic deformation of the passed-through material of the components (1, 2) in the direction transversely to the relative movement of the projection (3a-c) by deforming the carrier element (5).

17. An apparatus for assembling at least two components according to claim 16, **characterized in that** the projection (3a-c), which is movable relative in the direction towards the counterholder (4), comprises at least one cutting edge in order to carry out a partial cutting process at both components (1, 2) along at least one line during the passing movement through the components (1, 2), wherein preferably the cutting edge is a straight line and/or wherein the projection (3a-c) has two parallel cutting edges.

18. An apparatus for assembling at least two components according to at least one of claims 16 or 17, **characterized in that** the counterholder (4) is formed as a planar counterholder plate that can be contacted with the carrier element (5), and/or **in that** the carrier element (5) is made of a elastic or and/or plastically deformable material.

19. An apparatus for assembling at least two components according to at least one of claims 16 to 18, **characterized in that** the components are at least a first and a second foil (1, 2) or comprise at least a first and a second foil section, which contact each other at least in the assembly portion, and the carrier element consists of a carrier foil (5) which contacts the first foil (1) at least in the assembly portion, wherein preferably the carrier foil (5) comprises paper and/or plastics and/or metal and furthermore the carrier foil is uncoated or coated and/or has a sandwich structure and/or the carrier foil has a thickness in a range larger than 0 µm to approx. 300 µm.

20. An apparatus for assembling at least two components according to at least one of claims 16 to 19, **characterized in that** the projection (3a-c) is formed as a micro-structure on a movable assembly die (6) or the counterholder, wherein preferably the movable assembly die (6) is formed in a downholder (7), and/or wherein the micro-structure has a width and a height smaller than 1 mm, and/or the assembly portion has a size of approx. 1 mm².

21. An apparatus for assembling at least two components according to at lest one of claims 16 to 20, **characterized in that** the projection (3a-c) is formed in a catwalk-shaped manner, particularly **in that** a plurality of, particularly three, projections (3a-c) are provided for one single assembly portion for parallelly passing-through material, wherein preferably at least two, particularly three, web-shaped projections (3a-c) are provided in parallel to each other for one single assembly portion.

## Revendications

1. Procédé d'assemblage d'au moins deux composants (1, 2), qui sont placés l'un sur l'autre au moins dans une zone d'assemblage, dans lequel un élément support (5) est en contact avec un premier (1) des deux composants (1, 2) au moins dans la zone d'assemblage, au moins une avancée (3a-c) pénètre dans les composants (1, 2) dans la zone d'assemblage en direction de l'élément support (5), l'élément support (5) est supporté en surface au moins dans la zone d'assemblage pour résister au mouvement de pénétration de l'avancée (3a-c), et la pénétration des composants (1, 2) par l'avancée (3a-c) et le support de surface contraire de l'élément support (5) provoquent une déformation plastique de la matière des composants (1, 2) qui a été pénétrée dans une direction transversale par rapport au mouvement de pénétration de l'avancée (3a-c), en déformant l'élément support (5).

2. Procédé d'assemblage d'au moins deux composants selon la revendication 1, **caractérisé en ce que** l'élément support (5) se compose d'un matériau élastique et / ou déformable plastiquement.

3. Procédé d'assemblage d'au moins deux composants selon la revendication 1 ou 2, **caractérisé en ce que** l'avancée (3a-c) pénètre dans un deuxième composant (2) et repousse la matière du deuxième composant (2) en direction du premier composant (1), et la matière du premier composant (1) en direction de l'élément support (5), et la matière repoussée du premier et du deuxième composants (1, 2) pénètre sensiblement dans l'élément support (5), la déformation plastique de la matière des composants (1, 2) qui a été pénétrée formant une zone de contre-dépouille avec le premier et le deuxième composants (1, 2) dans le sens transversal par rapport au mouvement de pénétration.

4. Procédé d'assemblage d'au moins deux composants selon l'une des revendications 1 à 3, **caractérisé en ce que** l'avancée (3a-c) réalise une opération de coupe partielle sur les deux composants (1, 2) le long d'au moins une ligne lors du mouvement de pénétration dans les composants (1, 2), l'opération de coupe s'effectuant de préférence le long d'au moins une droite parallèle, et en outre, de préférence, au moins le long de deux droites parallèles.

5. Procédé d'assemblage d'au moins deux composants selon au moins une des revendications 1 à 4, **caractérisé en ce que** le mouvement de pénétration de l'avancée (3a-c) s'effectue dans un unique mouvement de course continu et / ou **en ce que** le support de surface de l'élément support (5) s'effectue dans un plan, le support de l'élément support (5) s'effectuant de préférence sur une grande surface.

6. Procédé d'assemblage d'au moins deux composants selon au moins une des revendications 1 à 5, **caractérisé en ce que** les composants sont au moins une première et une deuxième feuille (1, 2) ou comportent au moins une première et une deuxième section de feuille, qui sont situées l'une sur l'autre au moins dans la zone d'assemblage, dans lequel la première et la deuxième feuille (1, 2) ou bien la première et la deuxième section de feuille sont, de préférence, en contact l'une avec l'autre sur une grande surface et / ou les feuilles (1, 2) ou les sections de feuille comportent du papier et / ou du plastique et / ou du métal, et / ou les feuilles (1, 2) ou les sections de feuille sont non revêtues ou revêtues et / ou présentent une structure sandwich.

7. Procédé d'assemblage d'au moins deux composants selon la revendication 6, **caractérisé en ce que** les feuilles (1, 2) ou les sections de feuille présentent respectivement une épaisseur dans une plage de plus de 0 µm à environ 300 µm et / ou que, avant l'assemblage, la première et la deuxième feuille (1, 2) sont reliées au moins par zone de manière adhérente, notamment par collage et / ou par soudage.

8. Procédé d'assemblage d'au moins deux composants selon au moins une des revendications 6 ou 7, **caractérisé en ce que** la première feuille (1) présente une couche électriquement conductrice et la deuxième feuille (2) présente une couche électriquement conductrice, la couche électriquement conductrice de la première feuille (1) et la couche électriquement conductrice de la deuxième feuille (2) étant de préférence isolées électriquement l'une vis-à-vis de l'autre, et dans lequel un contact électrique entre la couche électriquement conductrice de la première feuille (1) et la couche électriquement conductrice de la deuxième feuille (2) est créé par le mouvement de pénétration de l'avancée (3a-c) dans la zone d'assemblage de la première et de la deuxième feuille (1, 2).

9. Procédé d'assemblage d'au moins deux composants selon au moins une des revendications 6 à 8, **caractérisé en ce que** l'élément support se compose d'une feuille support (5), qui est en contact avec la première feuille (1) au moins dans la zone d'assemblage, la première feuille (1) et la feuille support (5) étant de préférence en contact l'une avec l'autre sur une grande surface.

10. Procédé d'assemblage d'au moins deux composants selon la revendication 9, **caractérisé en ce que** la feuille support (5) comporte du papier et / ou du plastique et / ou du métal et / ou la feuille support (5) est non revêtue ou revêtue et / ou présente une structure en sandwich, la feuille support (5) présentant de préférence respectivement une épaisseur dans une plage de plus de 0 µm à environ 300 µm.

11. Procédé d'assemblage d'au moins deux composants selon au moins une des revendications 9 ou 10, **caractérisé en ce que,** avant l'assemblage, la feuille support (5) est reliée à la première feuille (1) au moins par zone de manière adhérente, notamment par collage et / ou par soudage, et / ou que la première feuille (1) est revêtue avec la feuille support (5) au moins dans la zone d'assemblage.

12. Procédé d'assemblage d'au moins deux composants selon au moins une des revendications 6 à 11, **caractérisé en ce que** la zone d'assemblage de la première et de la deuxième feuille (1, 2) présente une taille d'environ 1 mm².

13. Procédé d'assemblage d'au moins deux composants selon au moins une des revendications 6 à 12, **caractérisé en ce que** l'avancée (3a-c) prend la forme d'une microstructure sur un poinçon d'assemblage (6) ou une matrice, la microstructure présentant de préférence une largeur et une hauteur respectivement inférieures à 1 mm, et / ou **en ce que** l'avancée (3a-c) prend la forme d'une âme.

14. Procédé d'assemblage d'au moins deux composants selon au moins une des revendications 6 à 13, **caractérisé en ce qu'**une multitude d'avancées (3a-c) sont prévues pour une unique zone d'assemblage pour une pénétration parallèle de la matière, de préférence au moins deux, notamment trois avancées (3a-c) prenant la forme d'une âme étant prévues parallèlement les unes aux autres pour une unique zone d'assemblage.

15. Procédé d'assemblage d'au moins deux composants selon au moins une des revendications 1 à 14, **caractérisé en ce que** l'introduction de la force sur les avancées (3a-c) s'effectue de manière soudaine coup par le biais d'un poinçon (6) et / ou une matrice (4).

16. Dispositif d'assemblage d'au moins deux composants (1, 2), qui sont en contact l'un avec l'autre au moins dans une zone d'assemblage, avec au moins une avancée (3a-c) et une matrice (4) opposée, dans lequel l'avancée (3a-c) est prévue pour la pénétration des composants (1, 2) dans la zone d'assemblage, un élément support (5) est prévu entre un premier (1) des deux composants (1, 2) et la matrice (4) et est en contact avec le premier composant (1) et la matrice (4) au moins dans la zone d'assemblage, et la matrice (4) est prévue pour le support de surface de l'élément support (5) au moins dans la zone d'assemblage pour résister au mouvement de pénétration de l'avancée (3a-c), et la pénétration des composants (1, 2) par l'avancée (3a-c) et le support de surface contraire de l'élément support (5) provoquent une déformation plastique de la matière des composants (1, 2) qui a été pénétrée dans une direction transversale par rapport au mouvement relatif de l'avancée (3a-c), en déformant l'élément support (5).

17. Dispositif d'assemblage d'au moins deux composants selon la revendication 16, **caractérisé en ce que** l'avancée (3a-c), qui peut être déplacée de préférence relativement dans la direction de la matrice (4), présente au moins une arête coupante pour effectuer une opération de coupe partielle sur les deux composants (1, 2) le long d'au moins une ligne lors du mouvement de pénétration des composants (1, 2), l'arête coupante étant de préférence une droite et / ou l'avancée (3a-c) présentant deux arêtes coupantes parallèles.

18. Dispositif d'assemblage d'au moins deux composants selon au moins une des revendications 16 ou 17, **caractérisé en ce que** la matrice (4) prend la forme d'une plaque de matrice plane, qui peut être mise en contact avec l'élément support (5), et / ou **en ce que** l'élément support (5) se compose d'un matériau élastique et / ou déformable plastiquement.

19. Dispositif d'assemblage d'au moins deux composants selon au moins une des revendications 16 à 18, **caractérisé en ce que** les composants sont au moins une première et une deuxième feuille (1, 2) ou présentent au moins une première et une deuxième section de feuilles, qui sont situées l'une sur l'autre au moins dans la zone d'assemblage, et l'élément support se compose d'une feuille support (5), qui est en contact avec la première feuille (1) au moins dans la zone d'assemblage, dans lequel la feuille support (5) comporte du papier et / ou du plastique et / ou du métal, et est en outre de préférence non revêtue ou revêtue et / ou présente une structure en sandwich, et / ou présente en particulier une épaisseur dans une zone de plus de 0 µm à environ 300 µm.

20. Dispositif d'assemblage d'au moins deux composants selon au moins une des revendications 16 à 19, **caractérisé en ce que** l'avancée (3a-c) prend la forme d'une microstructure sur un poinçon d'assemblage (6) mobile ou une matrice, le poinçon d'assemblage (6) mobile étant de préférence conduit dans un serre-flan (7), et / ou la microstructure présentant une largeur et une hauteur respectivement inférieures à 1 mm, et / ou la zone d'assemblage présente une taille d'environ 1 mm².

21. Dispositif d'assemblage d'au moins deux composants selon au moins une des revendications 16 à 20, **caractérisé en ce que** l'avancée (3a-c) prend la forme d'une âme, et en particulier **en ce qu'**une multitude d'avancées (3a-c), notamment trois, sont prévues pour une unique zone d'assemblage pour la pénétration parallèle de la matière, où de préférence au moins deux, notamment trois, avancées (3a-c) en forme d'âme parallèlement l'une à l'autre sont prévues pour une unique zone d'assemblage.
